# EUROPÄISCHE PATENTSCHRIFT

(11) **EP 4 356 522 B1**
(45) Veröffentlichungstag und Bekanntmachung des Hinweises auf die Patenterteilung: **17.12.2025**
(21) Anmeldenummer: 22735096.4
(22) Anmeldetag: 08.06.2022
(51) Int. Cl.: H03K 17/955

(54) **VERFAHREN ZUR AUSWERTUNG EINER SENSORVORRICHTUNG**
METHOD FOR EVALUATING A SENSOR DEVICE
PROCÉDÉ D'ÉVALUATION D'UN DISPOSITIF CAPTEUR

(30) Priorität: 14.06.2021 DE 102021115259
(43) Veröffentlichungstag der Anmeldung: 24.04.2024
(73) Patentinhaber: HUF Hülsbeck & Fürst GmbH & Co. KG, 42551 Velbert (DE)
(72) Erfinder: CARVALHO, Luis Filipe, Seoul 06977 (KR); WEHNER, Philipp, 45879 Gelsenkirchen (DE); JOSEPH, Jobish, 42553 Velbert (DE)
(74) Vertreter: Zenz Patentanwälte Partnerschaft mbB
(86) Internationale Anmeldenummer: PCT/EP2022/065492
(87) Internationale Veröffentlichungsnummer: WO 2022/263246

(56) Entgegenhaltungen:
- WO-A1-2015/113554
- DE-A1- 102013 110 506

## Beschreibung

Die Erfindung betrifft ein Verfahren zur Auswertung einer Sensorvorrichtung. Insbesondere betrifft die Erfindung ein Verfahren, bei dem eine Sensorvorrichtung verwendet wird, die wenigstens einen Näherungssensor aufweist, welcher die räumliche Annäherung von Körpern erfasst. Die Sensorvorrichtung weist weiterhin eine Steuer- und Auswerteeinrichtung auf, die mit dem Näherungssensor gekoppelt ist und die ihrerseits einen Signalausgang aufweist.

Sensorvorrichtungen der genannten Art werden an Kraftfahrzeugen zur Erkennung von Bedienungsgesten eingesetzt. Beispielsweise finden solche Sensorvorrichtungen mit kapazitiven oder optischen Näherungssensoren, gelegentlich auch mit Ultraschallsensoren oder Radarsensoren am Fahrzeug Einsatzmöglichkeiten, bei denen eine Fahrzeugfunktion durch die Ausführung einer Bediengeste ausgelöst werden soll. Eine Bedienung von z.B. Türen oder Klappen, insbesondere Heckklappen kann auf diese Weise weitgehend kontaktlos erfolgen. Kontaktlos bedeutet in diesem Zusammenhang, dass der Bediener keine entriegelnde Manipulation an einem Türschloss oder Türgriff vornehmen muss.

Die Messwerte des Näherungssensors werden in den bekannten Verfahren ausgewertet, um festzustellen, ob ein zeitlicher Signalverlauf der vom Näherungssensor ausgegebenen Daten vorgegebenen Kriterien entspricht, die einen validen Betätigungswunsch eines Benutzers kennzeichnen. Dafür kann beispielsweise ein komplexer Mustervergleich durchgeführt werden, es können jedoch auch einfache zeitliche Charakteristika des Signalverlaufes, ebenso wie Werteänderungen innerhalb gewisser Zeiträume verglichen werden. Ist der Näherungssensor beispielsweise als kapazitiver Sensor im Heckbereich eines Fahrzeuges angeordnet so ist regelmäßig vorgesehen, dass ein Benutzer eine Schwenkbewegung des Beins oder Fußes zunächst in eine Richtung auf das Fahrzeug zu und dann wieder zurück durchführen muss, um einen Bedienwunsch auszudrücken. Ein solcher Kicksensor wird entsprechend eine Auswertung vornehmen, ob der Näherungssensor innerhalb eines gewissen Zeitbereiches zunächst einer Annäherung eines Körpers und anschließend wieder eine Entfernung des Körpers erfasst. Auch andere Gesten und Bewegungen können zur Bedienung eingesetzt werden. Zur grundsätzlichen Erkennung derartiger Bedienmuster sind zahlreiche Realisierungen im Stand der Technik bekannt. Ebenso sind zahlreiche Konstruktionen zu Sensorvorrichtungen mit Näherungssensoren und zugeordneten Steuer- und Auswerteeinrichtungen bekannt.

Beispielsweise offenbart das Dokument DE 10 2012 100 960 eine entsprechende Sensorvorrichtung und einen zugeordneten Auswertealgorithmus. Eine alternative Gestaltung, bei der ein zeitlicher Signalverlauf eines Näherungssensors einer Mustererkennung unterworfen wird, ist der DE 10 2014 100 974 zu entnehmen.

Das Dokument DE102013110506(A1) beschreibt ein Verfahren zur Betätigungsabfrage einer Funktion an einem Kraftfahrzeug durch den Einsatz einer Sensoranordnung. Diese Anordnung besteht aus mindestens zwei Sensoreinrichtungen, die räumlich voneinander getrennt sind und zur Erfassung von Bedienungen durch Annäherung eines Körperteils eines Benutzers dienen. Nach der Erkennung einer charakteristischen ersten Signalantwort durch die erste Sensoreinrichtung wird die Identität des Benutzers mittels eines tragbaren ID-Gebers verifiziert. Sobald eine Bedienung durch Annäherung an die zweite Sensoreinrichtung festgestellt wird, werden Signale beider Sensoren für eine festgelegte Zeit überwacht. Zeigen die Signale während dieser Zeit eine fortgesetzte Bedienung an, wird dem Benutzer das Ende dieser Zeitdauer angezeigt. Falls anschließend die erste Sensoreinrichtung das Ende der Bedienung signalisiert, wird die gewünschte Funktion im Kraftfahrzeug aktiviert.

Das Dokument WO2015113554A1 offenbart ein Emblem für ein Kraftfahrzeug, das ein optisches Sensorsystem integriert. Dieses System ist darauf ausgerichtet, einen bestimmten Detektionsbereich außerhalb des Fahrzeugs zu überwachen. Bei Erkennung eines Benutzers in diesem Bereich wird ein Signal ausgelöst, das eine Authentifizierungsüberprüfung zwischen einem tragbaren ID-Geber und dem Fahrzeug initiiert. Zusätzlich überwacht das Sensorsystem einen zweiten, vom ersten unterschiedlichen Betätigungsbereich. Wird ein Benutzer auch hier erkannt, stellt das System ein Arbeitssignal für das Fahrzeug bereit, welches für weitere Funktionen genutzt werden kann.

Den bekannten Systemen ist gemeinsam, dass Signalverläufe von Näherungssensoren ausgewertet werden und nach einer Auswertung entschieden wird, ob tatsächlich ein Bedienwunsch des Benutzers vorliegt oder nicht. Gleichzeitig mit einer laufenden Auswertung oder nachgeordnet kann außerdem noch eine Autorisierungsabfrage erfolgen, die eine drahtlose Abfrage von einem Fahrzeugschlüssel oder einem sonstigen Legitimationsmittel bewirkt, welches ein Bediener mit sich führen muss, um die Fahrzeugfunktion tatsächlich auszulösen.

Während die grundsätzliche Funktion derartiger Betätigungseinrichtungen und der Verfahren zu deren Betrieb inzwischen weit verbreitet und erprobt ist, ist die Akzeptanz bei den Benutzern und Bedienern nicht immer zufriedenstellend. Bediener sind sich häufig nicht sicher, ob sie eine Bediengeste richtig ausführen oder ob das Fahrzeug sich überhaupt in einem Zustand befindet, in dem es eine ausgeführte Betätigungsgeste detektiert. Zur Bedienerleichterung wurden bereits zahlreiche Verbesserungen vorgeschlagen, beispielsweise die optische Markierung eines Bereichs, in dem die Bediengeste auszuführen ist (siehe zum Beispiel DE 10 2014 106 939).

Derartige Systeme bringen jedoch gelegentliche neue Probleme mit sich, da sie zum Beispiel unzulässige Lichtquellen am Auto erfordern oder auch bei unvorteilhaften Umgebungsbedingungen ihren Nutzen verlieren.

Aufgabe der Erfindung ist es, ein verbessertes Verfahren zur Verfügung zu stellen, welches den Bedienkomfort einer Sensoreinrichtung erhöht und außerdem eine verbesserte Bediensicherheit ermöglicht.

Diese Aufgabe wird gelöst durch ein Verfahren mit den Merkmalen des Patentanspruches **1.**

Gemäß der Erfindung werden im Verlauf des Erkennungsvorgangs eines Bedienereignisses mehrere verschiedene Signale am Signalausgang der Steuer- und Auswerteeinrichtung ausgegeben. Diese Steuer- und Auswerteeinrichtung ist über ihren Signalausgang üblicherweise mit einem Bussystem des Fahrzeuges oder einer sonstigen zentralen Steuereinheit eines Fahrzeuges koppelbar. Diese nimmt die von der Steuer- und Auswerteeinrichtung der Sensorvorrichtung empfangenen Signale entgegen und veranlasst, gegebenenfalls unter Heranziehung zusätzlicher Signale und Kriterien, nachgeordnete Aktionen, wie beispielsweise die Entriegelung einer Tür oder ein sonstiges Stellverfahren am Fahrzeug. Auch die Auslösung von drahtlosen Kommunikationen in Reaktion auf den Empfang eines Signals an der zentralen Steuereinheit von der Steuer- und Auswerteeinrichtung der Sensorvorrichtung ist möglich. Die nachgeordneten Aktionen sind jedoch nicht Bestandteil der Erfindung. Die Reaktion auf die ausgegebenen Signale kann durch Fahrzeughersteller individuell ausgewählt werden.

Gemäß der Erfindung wird zusätzlich zu dem zweiten Bediensignal, was erfindungsgemäß die Erkennung einer gültigen Bediengeste signalisiert, ein zeitlich vorgeordnetes erstes Bediensignal generiert und ausgegeben. Führt ein Benutzer am Fahrzeug im Detektionsbereich der Sensoreinrichtung und deren Näherungssensor eine Bediengeste aus, werden die Sensorwerte des Näherungssensors ausgewertet, um zu erkennen, ob diese Werte für eine gültig ausgeführte Bediengeste stehen. Wie im Stand der Technik beschrieben, können dafür verschiedenste Arten der Mustererkennung oder sonstigen Auswertungen herangezogen werden. Die Auswertung dieser Signalverläufe, die eine Bediengeste darstellen, also beispielsweise die Schwenkbewegung eines Fußes oder die Annäherung einer Hand, können durch Schwellwertvergleiche, Mustererkennungen durch neuronale Netze und sonstige Algorithmen erfasst und bewertet werden. Das konkret festgelegte Kriterium ist auch von der Art des verwendeten Näherungssensors abhängig, der z.B. als kapazitiver Sensor ausgebildet sein kann (das Verfahren ist jedoch grundsätzlich auch mit anderen Arten von Näherungssensoren einsetzbar). Da diese Erkennung von tatsächlichen Bedienereignissen zum Stand der Technik gehört, wird hier nicht weiter darauf eingegangen.

Bevor jedoch tatsächlich eine gültige Bedienung erkannt wird, wird erfindungsgemäß zeitlich vorgeordnet ein erstes Bediensignal erzeugt und durch die Steuer- und Auswertevorrichtung ausgegeben. Für dieses erste Bediensignal können gänzlich andere Kriterien herangezogen werden, als bei der Auswertung des gültigen vollständigen Bedienereignisses. Es kann sich also beispielsweise um eine Teilgruppe der Kriterien handeln, die auch bei der Auswertung des Bediensignals herangezogen wird oder um deutliche gröbere Kriterien, die bei der korrekten Ausführung eines Bedienereignisses erfüllt werden, wobei jedoch ggf. auch einige ungültige Bedienereignisse umfasst werden. Um das erste Bediensignal zu erzeugen wird dann, wenn eine beginnende Betätigung der Sensorvorrichtung durch die Steuer- und Auswerteeinrichtung erfasst wird, ein Timer t1 gestartet. Die Erkennung auf eine beginnende Betätigung kann insbesondere eine Änderung der Messwerte des Näherungssensors über eine gewisse Abweichung von der Ruhelage hinaus sein, beispielsweise also das Kreuzen eines Schwellwertes, der sich in einem vorgegebenen Abstand von dem langfristigen Mittelwert der Messwerte des Näherungssensors befindet oder eine vorgegebene prozentuale Abweichung von einem gleitenden Mittelwert. Wird eine solche Änderung der Messwerte erkannt, wird der erste Timer t1 gestartet und es wird die Erfassung der Messwerte an den Näherungssensoren fortgesetzt. Erreicht der erste Timer t1 einen ersten Zielwert tz1 und erfüllen die Messwerte seit dem Start des Timers und bis zum Erreichen des Zielwertes ein erstes Kriterium durchgehend, so wird das erste Bediensignal an dem Signalausgang ausgegeben und ausgegeben. Das erste Kriterium kann ein komplexes Kriterium sein, es kann sich jedoch auch um einen einfachen fortgesetzten Schwellwertvergleich handeln, so dass beim Rückfall der Messwerte in den Bereich des langfristigen Mittelwertes im unbedienten Zustand das Kriterium nicht erfüllt. Es kann auch vorgesehen sein, auf einen fortgesetzten monotonen Abfall der Messwerte an dem Näherungssensor hin zu überprüfen, wobei die Messwerte zuvor auch einer Glättung oder Filterung unterworfen werden können. Das erste Kriterium kann sich dabei hinsichtlich Datenmenge und Art des Kriteriums von den Kriterien unterscheiden, die für die Erkennung einer gültigen Bedienung herangezogen werden. Bei einer Gestaltung des ersten Kriteriums, welches nur geringen Rechenaufwand verursacht, kann daher die frühe Erkennung des ersten Kriteriums bei gleichzeitiger Überwachung auf eine vollständig korrekte Bedienung durchgeführt werden. Die Laufzeit des ersten Timers t1 (also der Zielwert tz1) ist im Rahmen der Erfindung so gewählt, dass diese Laufzeit deutlich kürzer bemessen ist, als die übliche Betätigungsdauer ist. Der Zielwert tz1 wird also im üblichen Betätigungsfall erreicht, bevor eine Betätigung vollständig durchgeführt wurde.

Eine nachgeordnete zentrale Steuereinrichtung kann das erste Bediensignal weiterverarbeiten und als Auslöser für eine Vielzahl von Vorgängen heranziehen, die jedoch noch nicht die endgültige Betätigung umfassen. Insbesondere ist es möglich, in Reaktion auf das erste Bediensignal eine Information an den Bediener selbst bereitzustellen, so dass dieser erfährt, dass eine Bedienauswertung läuft und sein laufender Betätigungsvorgang ausgewertet wird. Ein derartiges Feedback verbessert den Bedienkomfort für einen Benutzer erheblich, da er nicht erst bei endgültiger Auslösung der Bedienfunktion erfährt, ob das Fahrzeug beziehungsweise die Sensorvorrichtung überhaupt in einen aktiven und erfassenden Zustand übergegangen ist. Für eine solche Signalisierung an den Benutzer kommen beliebige Signale in Frage, die für den Benutzer wahrnehmbar sind, beispielsweise Betätigungen von Signalanlagen am Fahrzeug oder sonstigen Fahrzeugeinrichtungen (z.B. Innenraumbeleuchtung).

Auch bei dem und nach dem Erzeugen des ersten Bediensignals läuft die Erfassung der Messwerte weiter. Diese Fortsetzung der Erfassung der Messwerte wird gemäß den Kriterien fortgesetzt, die für eine übliche Erkennung der Betätigungsgeste herangezogen werden. Auch für solche Erkennungen gibt es üblicherweise Höchstdauern, nach denen eine Erkennung erfolglos abgebrochen wird. Wurde bei fortgesetzter Erfassung der Messwerte das zweite Kriterium erfüllt, welches zur Erkennung einer gültigen Ausführung einer Bediengeste ausgebildet ist und somit eine gültige Bedienung durch die Steuer- und Auswerteeinrichtung festgestellt, dann wird das zweite Bediensignal am Signalausgang der Steuer- und Auswertevorrichtung ausgegeben.

Wenn jedoch keine vollständig erfolgreiche Betätigung erkannt wurde und entsprechend kein zweites Bediensignal ausgegeben wurde, weil die Messwerte das zweite Kriterium nicht erfüllen, wird ein Fehlbetätigungssignal ausgegeben, was sich von dem ersten Bediensignal und dem zweiten Bediensignal unterscheidet.

Das Fehlbetätigungssignal wird also dann ausgegeben, wenn zwar eine Auswertung gestartet wurde, nachfolgend jedoch keine erfolgreiche Bedienung festgestellt wurde. Dies sorgt dafür, dass eine der Steuer- und Auswerteeinrichtung nachgeordnete Einheit (z.B. ein zentrales Steuergerät des Fahrzeugs) eine ggf. durch das erste Bediensignal erzeugte Wirkung am Fahrzeug oder auch nachgeordnet beim Bediener aufheben kann, so dass sich jederzeit ein konsistenter Bedienablauf und Eindruck für den Benutzer ergibt. Wurde beispielsweise das erste Bediensignal genutzt, um dem Bediener eine laufende Bedienerkennung zu signalisieren, so kann das Fehlbetätigungssignal verwendet werden, um den Bediener eine entsprechende erfolglose Detektion zur Kenntnis zu bringen. Dies erhöht die Akzeptanz für einen Bediener, da er jederzeit nachvollziehen kann, ob eine Bedienung hinsichtlich ihrer Erfassung läuft, ob diese erfolgreich war oder ob diese nicht erfolgreich erkannt wurde.

Wurde das erste Bediensignal hingegen nicht ausgegeben, liefert das Fehlbetätigungssignal allen nachgeordneten Einheiten auswertbare Anhaltspunkte für eine mögliche Fehlerkennung oder auch einen Servicebedarf der Einrichtung. Das Fehlbetätigungssignal zeigt an, dass eine Auswertung von Messdaten zwar vollumfänglich vorgenommen wurde, diese jedoch nicht einer Bedienung zuzuordnen sind. Diese Information kann sowohl im Fahrzeugsystem gespeichert und z.B. bei einem Service ausgelesen werden oder auch dem Bediener des Fahrzeuges zur Kenntnis gebracht werden. Es ist damit eine einfachere Unterscheidung von möglichen Fehlfunktionen möglich, da erkannt wurde, dass eine mögliche Betätigung erfolgt ist, als die Erkennung gestartet ist, die Messwerte jedoch nicht einer Bedienung zuzuordnen waren. Schließlich kann auch auf das Fehlbetätigungssignal hin eine Information oder Signalisierung an den Benutzer ausgegeben werden.

Erfindungsgemäß unterscheiden sich das erste und das zweite Bediensignal und das Fehlbetätigungssignal, so dass die nachgeordnete zentrale Steuereinrichtung, welche die Signale von der Steuer- und Auswertevorrichtung erhält, jederzeit zwischen den Signalen unterscheiden kann. Die Unterscheidung kann eine beliebige Unterscheidung in der Signalkodierung, Frequenz, dem Signalpegel oder Ähnlichem liegen.

Es ist eine bevorzugte Ausgestaltung des Verfahrens, wenn die Ausgabe des Fehlbetätigungssignals in Abhängigkeit von der Ausgabe des ersten Bediensignals erfolgt.

Erfindungsgemäß wird eine charakteristische Eigenschaft des Fehlbetätigungssignals durch die Steuer- und Auswerteeinrichtung in Abhängigkeit davon eingestellt, ob das erste Bediensignal ausgegeben wurde.

Die Steuer- und Auswerteeinrichtung hat für einen konkreten Benutzungsvorgang die Information, ob bereits ein erstes Bediensignal ausgegeben wurde. Eine Ausgabe des Fehlbetätigungssignals kann dann, wenn das erste Bediensignal nicht ausgegeben wurde, von der Steuer- und Auswerteeinrichtung unterdrückt werden. Es wird dann nur ein Fehlbetätigungssignal ausgegeben, wenn diesem ein erstes Bediensignal voranging.

Wurde dem Bediener auf das erste Bediensignal hin bereits ein Signal gegeben, kann dieses auf das Fehlbetätigungssignal hin aufgehoben werden bzw. mit einem weiteren Signal die Fehlbetätigung signalisiert werden. Dies ist jedoch nicht erforderlich, wenn das erste Bediensignal gar nicht ausgegeben wurde. Außerdem kann der Zeitpunkt der Ausgabe des Fehlbetätigungssignals in Abhängigkeit von dem Zeitpunkt des ersten Bediensignals erfolgen, z.B. mit einer vorgegebenen Verzögerung zum ersten Bediensignal, um jederzeit für eine auswertbare und auch wahrnehmbare Trennung der Signale zu sorgen.

In einer bevorzugten Gestaltung wird eine charakteristische Eigenschaft des Fehlbetätigungssignals durch die Steuer- und Auswerteeinrichtung in Abhängigkeit davon eingestellt wird, ob das erste Bediensignal ausgegeben wurde.

Während gemäß dem vorstehenden Beispiel auch entschieden werden kann, ob das Fehlbetätigungssignal bei Ausbleiben des ersten Bediensignals überhaupt ausgegeben wird ist es in dieser Gestaltung vorgesehen, Eigenschaften des Signals in Abhängigkeit von dem Versand des ersten Bediensignals zu wählen. Auf diese Weise wird also immer ein Fehlbetätigungssignal ausgegeben, wenn zwar eine Bedienvorgangserfassung begonnen, die Bedienung nicht erkannt wurde, die Eigenschaften des Fehlbetätigungssignals sind aber unterschiedlich, je nachdem, ob zuvor ein erstes Bediensignal versandt wurde oder nicht. Eine nachgeordnete Einrichtung kann dann zwischen diesen Signalen differenzieren. Werden die Informationen unterschiedlich codiert, könne sie leichter in eine nachgeordneten Verarbeitungsweg gespeist werden.

Besonders bevorzugt ist es, wenn sich das erste und das zweite Bediensignal und das Fehlbetätigungssignal in ihrer Signallänge unterscheiden.

Eine Längenkodierung der Signale ermöglicht eine besonders einfache und verlässliche Übertragung in einem Signalsystem eines Fahrzeuges, beispielsweise über ein Bussystem.

In einer bevorzugten Gestaltung der Erfindung enthält das erste Kriterium eine Bedingung, wonach die Messwerte einen vorgegeben ersten Schwellwert nicht kreuzen.

Gemäß diesem Kriterium wird überprüft, ob innerhalb der Laufzeit des ersten Timers t1 ein Durchgang durch einen Schwellwert festgestellt werden kann. Hierbei ist es beispielsweise möglich, das erste Ansteigen oder Abfallen der Messwerte oberhalb oder unterhalb eines Schwellwertes als Kriterium zum Start des Timers t1, also zur Erkennung des einsetzenden Bedienereignisses heranzuziehen. Danach wird bis zum Ablauf des ersten Timers t1 geprüft, ob das Signal wieder in Richtung des Ausgangsniveaus abfällt beziehungsweise ansteigt. Ist dies nicht der Fall, hat also das Signal für die vorgegebene Zeitdauer den Schwellwert nicht erneut gekreuzt, so wird das erste Bediensignal, gegebenenfalls nach Prüfung auf Erfüllung weiterer Bedingungen, ausgegeben. Der Vorteil in einer solch einfachen Schwellwertprüfung liegt in den geringen rechnerischen Anforderungen an die Auswertungen und Berechnungen. Um ein entsprechendes Systems möglichst einfach zu gestalten, sind geringe Anforderungen an die Rechenleistung vorteilhaft, insbesondere da die tatsächliche spätere Erkennung eines Bedienereignisses gegebenenfalls sämtliche verfügbaren Ressourcen benötigt, um eine rasche Auswertung vornehmen zu können. Es hat sich außerdem gezeigt, dass durch einen einfachen Schwellwertvergleich der ganz wesentliche Anteil von einsetzenden Bedienereignissen korrekt erkannt werden kann, wobei der Schwellwert empirisch und je nach Fahrzeugmodell festgesetzt wird.

In einer bevorzugten Weiterbildung der Erfindung weist die Sensorvorrichtung wenigstens 2 Näherungssensoren auf, die jeweils Messwerte liefern und die beide für die Auswertung zur Generierung des ersten Bediensignals herangezogen werden. Bis also der erste Timer t1 den Zielwert erreicht hat, werden die Sensorwerte beider Näherungssensoren herangezogen, was eine feinere und verlässlichere frühe Auswertung zur Erzeugung des ersten Bediensignals erlaubt. Beispielsweise können beide Messwertreihen einem Schwellwertvergleich unterworfen werden, wobei jedem Näherungssensor ein spezifischer Schwellwert zum Vergleich zugeordnet ist. In herkömmlichen Sensoreinrichtungen, wie sie beispielsweise im Heckbereich eines Fahrzeuges zum Einsatz kommen, liegen mehrere Näherungssensoren, meist in Gestalt von kapazitiven Näherungssensoren an verschiedenen Positionen der Außenhaut des Fahrzeuges vor. Beispielsweise ist ein erster Näherungssensor im Stoßfänger angeordnet während ein zweiter Näherungssensor unterhalb und weiter in Richtung Fahrzeugmitte positioniert ist. Wird eine Schwenkbewegung des Fußes in diesem Bereich ausgeführt, detektieren beide Näherungssensoren, jedoch aufgrund ihrer Lage zeitversetzt, eine Signaländerung. Als erstes Kriterium können dann beispielsweise für die beiden Näherungssensoren einfache Wertevergleiche herangezogen werden, es kann jedoch auch der zeitliche Verlauf der Messwerte der Näherungssensoren geprüft werden, beispielsweise ob beide Näherungssensoren bis zum Erreichen des ersten Zielwertes durch den Timer t1 einen ansteigenden beziehungsweise abfallenden Verlauf zeigen.

In einer bevorzugten Weiterbildung der Erfindung ist vorgesehen, dass der Timer t1 nicht nur für die Auswertung zur Erzeugung des ersten Bediensignals herangezogen wird, sondern danach fortlaufend überwacht wird. Es kann dann vorgesehen sein, dass eine Erreichung eines zweiten Zielwertes TZ2 durch den Timer t1 eine zeitliche Begrenzung zur Erkennung eines gültigen Bedienereignisses dient. Wird also bis zum zweiten Zielwert TZ2 durch die Steuer- und Auswerteeinrichtung nicht erkannt, dass ein gültiges Bedienereignis durch vollständige Ausführung einer korrekten Bediengeste vorliegt, so wird das Bedienereignis verworfen. Auf diese Weise ist eine konsistente Maximaldauer einer möglichen Bedienung vorgegeben, die für einen Benutzer ersichtlich und nachvollziehbar ist.

Es ist vorteilhaft, wenn die Steuer- und Auswerteeinrichtung derart betrieben wird, dass die am Signalausgang ausgegebenen Signale mit einem zeitlichen Mindestabstand TD versandt werden. Die Steuer- und Auswerteeinrichtung sorgt dann dafür, dass auch dann, wenn mehrere Signale zeitgleich oder kurz nacheinander ausgegeben werden sollen, eine Mindestverzögerung eingehalten wird, um eine fehlerfreie Signalübertragung im Fahrzeugsystem jederzeit zu gewährleisten. Dies ist insbesondere dann relevant, wenn das erste Bediensignal und das zweite Bediensignal oder das Fehlbetätigungssignal weitgehend zeitgleich erzeugt werden. In jedem Fall sorgt eine Verzögerung im Betrieb der Steuer- und Auswerteeinrichtung dafür, dass der zeitliche Mindestabstand zwischen erstem Bediensignal und zweitem Bediensignal oder dem Fehlbetätigungssignal eingehalten wird.

Es ist besonders bevorzugt, wenn das erste Bediensignal verwendet wird, um einem Bediener durch akustische oder optische Signale das laufende Auswerteverfahren zur Kenntnis zu bringen. Der Zweck dieses Vorgangs liegt in der nachvollziehbaren Bedienerführung, da ein Benutzer durch ein solches optisches oder akustisches Feedback jederzeit über den aktuellen Ablauf des Verfahrens informiert ist.

Auch das Fehlbetätigungssignal kann verwendet werden, um einem Bediener durch akustische oder optische Signale das gescheiterte Auswerteverfahren zur Kenntnis zu bringen. Der Zweck auch dieses Vorgangs liegt in der nachvollziehbaren Bedienerführung, da ein Benutzer durch ein solches optisches oder akustisches Feedback jederzeit über den aktuellen Ablauf des Verfahrens informiert ist.

In einer abgewandelten Gestaltung des Verfahrens kann zusätzlich oder alternativ zu einer optischen oder akustischen Signalisierung auf das erste Bediensignal hin dieses erste Bediensignal als Trigger zur Auslösung einer drahtlosen Funkkommunikation zur Berechtigungsabfrage eines vom Bediener mitgeführten ID-Gebers verwendet werden.

Da das erste Bediensignal zeitlich dem zweiten Bediensignal zur Signalisierung einer erfolgreichen Öffnung vorangeht, kann dieser Zeitgewinn genutzt werden, um eine drahtlose Abfrage eines ID-Gebers zu starten, die einer späteren Auslösung einer Fahrzeugfunktion, insbesondere einer Türöffnung ohnehin vorangehen muss. Wird das erste Bediensignal für diese Zwecke eingesetzt, ist dies mit einem angenehmen Benutzererlebnis sowie einer verbesserten Akzeptanz verbunden.

In einer Weiterbildung der Erfindung wird dann, wenn durch die Steuer- und Auswerteeinrichtung eine gültige Bedienung festgestellt wird zunächst noch überprüft, ob tatsächlich bereits ein erstes Bediensignal ausgegeben wurde. Dies stellt sicher, dass immer dann, wenn ein zweites Bediensignal ausgegeben wird, diesem zweiten Bediensignal ein erstes Bediensignal vorangeht. Dadurch ist gewährleistet, dass dem Bediener ein konsistentes Bedienerlebnis entgegentritt, dass also niemals eine Auslösung einer Bedienung erkannt wird, ohne dass das erste Bediensignal ausgegeben wurde. Eine solche Überprüfung ist nötig, da - wie oben gesagt - die Kriterien zur Erzeugung des ersten Bediensignals von den Kriterien zur Erkennung einer erfolgreichen Bedienung abweichen können. Das erste Bediensignal wird auf Basis einer frühen Auswertung ausgegeben, so dass es durchaus passieren kann, dass die nachgeordnete Auswertung ergibt, dass tatsächlich eine gültige Bedienung vorlag, während die frühe Auswertung das erste Kriterium zur Erzeugung des Bediensignals nicht erfüllt hatte. Ist das erste Kriterium beispielsweise ein einfacher Schwellwertvergleich, bei dem überprüft wird, ob die Messwerte während der Laufzeit des ersten Timers dauerhaft oberhalb oder unterhalb eines vorgegebenen Schwellwertes liegen, kann eine einzelne Wertabweichung schon zum Scheitern der Validierung dieses Kriteriums führen. Wird beispielsweise aus irgendeinem Grund der Signalübertragung ein Nullwert geliefert, würde das erste Kriterium gegebenenfalls als nicht erfüllt angesehen. Die komplexere und gegebenenfalls mit Glättungen und Filtern arbeitende Auswertung zur Erzeugung des zweiten Bediensignals bei einer tatsächlich korrekt durchgeführten vollständigen Betätigung, könnte solche Fehler ausmerzen und feststellen, dass tatsächlich eine gültige Bedienung vorliegt. Dann wird, obwohl bis zum Zeitpunkt tz1 das erste Kriterium nicht erfüllt wurde, nachträglich noch das erste Bediensignal erzeugt und ausgegeben, gefolgt von dem zweiten Bediensignal. So ist jederzeit gewährleistet, dass ein zweites Bediensignal nur mit einem vorgehenden ersten Bediensignal ausgegeben wird. Wenn die zentrale Steuereinheit also eine technische Reaktion auf das erste Bediensignal hin auslöst, ist jederzeit darauf Verlass, dass diese Aktion auch vor einer tatsächlichen Bedienbetätigung ausgeführt wird.

Die Erfindung wird im Folgenden anhand der beiliegenden Zeichnung näher erläutert.
Figur 1a zeigt die Heckansicht eines Fahrzeuges zur Ausführung des erfindungsgemäßen Verfahrens;
Figur 1b zeigt eine schematische Seitenansicht des Fahrzeuges aus Figur 1a;
Figur 2 zeigt einen Ablaufplan einer Ausführungsform des erfindungsgemäßen Verfahrens.

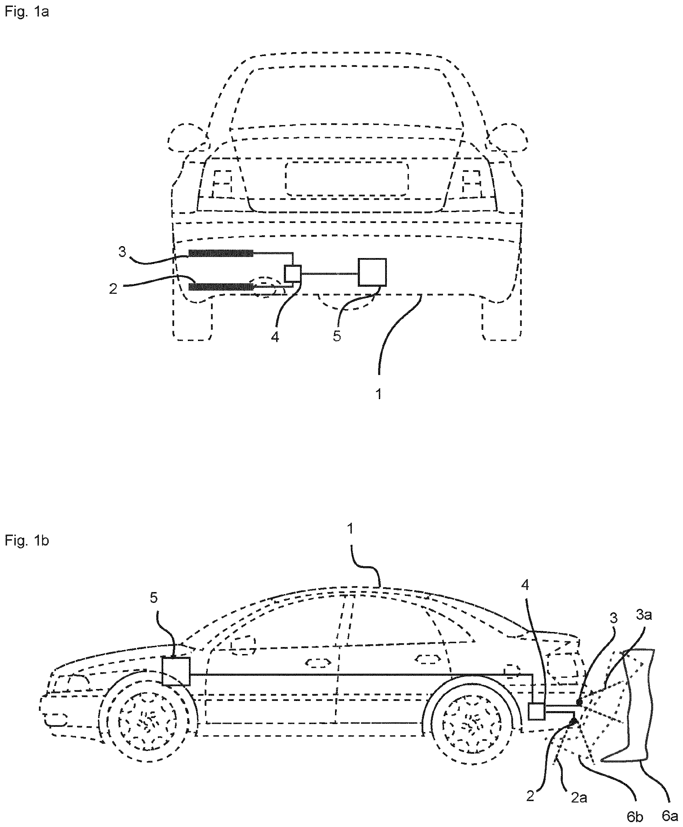

In den Figuren 1a und 1b ist ein Fahrzeug 1 gezeigt, bei dem im Heckbereich Näherungssensor-Elektroden 2, 3 angeordnet sind. Diese Näherungssensor-Elektroden sind mit einer Steuer- und Auswerteeinrichtung 4 verbunden, welches die Näherungssensor-Elektroden als kapazitive Elektroden ansteuert und die jeweilige Kapazität ermittelt. Dieses Steuergerät 4 ist wiederum mit einem zentralen Steuergerät 5 des Fahrzeuges gekoppelt. Die Steuer- und Auswerteeinrichtung 4 übernimmt die Ansteuerung der Elektroden 2, 3 und die Signalauswertung, also die Ermittlung der Signalantworten und Zuordnung zu einem Bediensignal. Ein eventuell erzeugtes Bediensignal wird von der Steuer- und Auswerteeinrichtung 4 zu der zentralen Steuereinrichtung 5 übermittelt, welche die Schließfunktion der Heckklappe und die elektrische Öffnung ausführen kann.

Die Elektrode 2 ist im unteren Heckbereich angeordnet und ihr Erfassungsbereich 2a ist nach unten gerichtet, wie in Figur 1b gezeigt. Elektrode 3 ist so angeordnet, dass ihr Erfassungsbereich 3a nach hinten gerichtet ist.

In Figur 1b ist das Bein 6a, 6b eines Benutzers in 2 verschiedenen Positionen gezeigt. In der Position 6a steht der Benutzer hinter dem Heck des Fahrzeuges und das Bein des Benutzers ist ggf. durch die Sensoranordnung 3 mit dem Erfassungsbereich 3a zu erfassen, nicht jedoch durch die Sensoranordnung 2 mit ihrem Erfassungsbereich 2a. Tritt der Benutzer jedoch dicht an die Heckklappe heran und bringt seinen Fuß in den Erfassungsbereich 2a, wie es in der Position 6b gezeigt ist, so ist sowohl eine Erfassung im Bereich 3a also auch eine Erfassung im Bereich 2a möglich. Für eine erfolgreiche Bedienungserkennung wird es erforderlich sein, dass sowohl der Sensor 2 als auch der Sensor 3 zeitliche Signalabläufe liefern, die mit einem in der Steuer- und Auswerteeinrichtung 4 gespeicherten Kriterium konform sind. Dabei kann beispielsweise berücksichtigt sein, wie lange das Bein des Benutzers in der Position 6b verbleiben muss, um eine erfolgreiche Betätigung zu erkennen und wie sich die Messwerte des Sensors 2 und des Sensors 3 jeweils in zeitlicher Folge verändern. Wie eine solche Erkennung abläuft und ein entsprechendes zweites Bediensignal ausgegeben wird, ist im Stand der Technik ausführlich beschrieben. Die Steuer- und Auswerteeinrichtung kann insbesondere Mustervergleiche oder Schwellwertvergleiche durchführen oder auch ein neuronales Netz enthalten, um die tatsächliche Bedienung von Störsignalen, verursacht durch andere Objekte oder Umgebungsbedingungen, zu unterscheiden.

Erfindungsgemäß wird jedoch dem zweiten Bediensignal, welches eine erfolgreiche Betätigung an das zentrale Steuergerät 5 signalisiert, ein erstes Bediensignal vorangehen. Zur Erzeugung des ersten Bediensignals wird bei Erkennung einer einsetzenden Bedienung zunächst ein Timer t1 gestartet. Dieser Timer kann im vorliegenden Beispiel gestartet werden, sobald der Näherungssensor-Elektrode 3 und der Näherungssensor-Elektrode 2 die Annäherung eines Objektes erfasst, was sich durch den Anstieg der Messwerte über einen jeweils zugeordneten Schwellwert äussert.

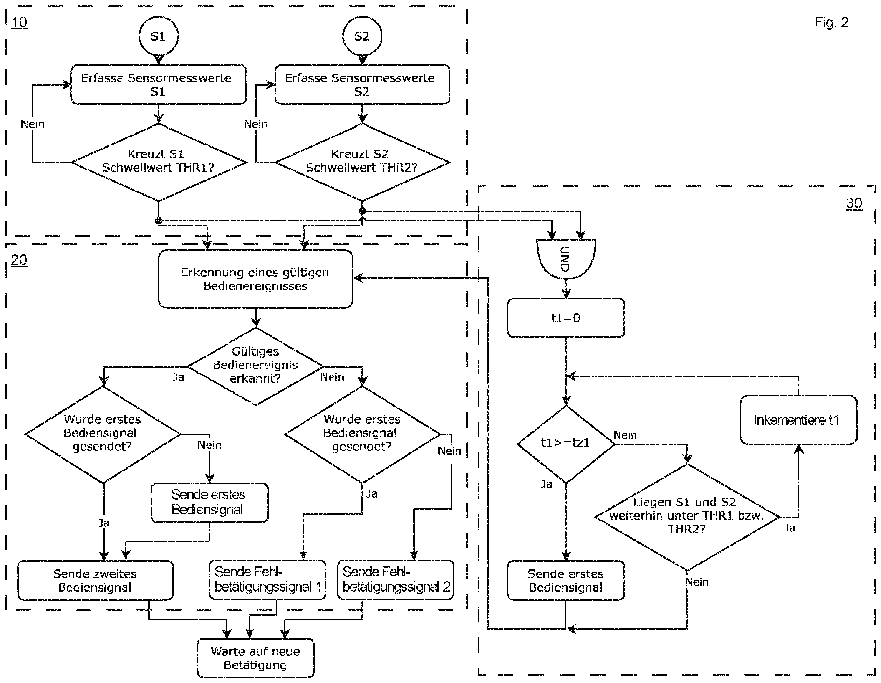

Während die Figuren 1a und 1b zur Verdeutlichung des Systems dienen, welches zur Durchführung des erfindungsgemäßen Verfahrens eingesetzt werden kann, zeigt Figur 2 das Ablaufschema des erfindungsgemäßen Verfahrens gemäß einer ersten Ausführungsform.

In einem ersten Abschnitt des erfindungsgemäßen Verfahrens, der in Figur 2 im Block 10 dargestellt ist, überwacht die Steuer- und Auswerteeinrichtung 4 die Signale S1 und S2, die jeweils einer der Näherungssensor-Elektroden 2 bzw. 3 zugeordnet sind. Diese Erfassung erfolgt in einer Schleife und so lange, bis bei beiden Näherungssensor-Elektroden 2, 3 ein Durchkreuzen der Messwerte eines jeweils zugeordneten Schwellwertes THR1 bzw. THR2 festgestellt wird. Eine solches Kreuzen der genannten Schwellwerte zeigt an, dass ein Einsetzen oder Beginnen eines Bedienereignis vorliegen könnte. Die durch die Näherungssensor-Elektroden 2, 3 erfasste Kapazität ändert sich dabei gegenüber dem vorherigen Zustand (einem Ruhezustand oder gleitendem Mittelwert) so stark, dass von der Nähe eines Benutzers auszugehen ist. Ist diese Bedingung erfüllt, wurden also an beiden Näherungssensor- Näherungssensor-Elektroden 2, 3 die zugeordneten Schwellwerte THR1 bzw. THR2 gekreuzt, so wird der Verfahrensblock 30 ausgeführt.

In dem Verfahrensblock 30 ist dargestellt, wie das erste Bediensignal ausgegeben wird und welche zugehörigen Kriterien in diesem Ausführungsbeispiel der Erfindung vorliegen. Zunächst wird der Timer t1 auf null gesetzt. Anschließend wird für eine Laufzeit des Timers t1, nämlich solange dieser kleiner ist als der Zielwert tz1 geprüft, ob die Signale S1 und S2, also die Messwerte der Näherungssensor-Elektroden 2, 3 weiterhin den zugeordneten Schwellwerte nicht wieder gekreuzt haben und in Richtung ihres Ausgangsniveaus gestiegen oder gefallen sind. Soweit hier von fallenden und steigenden Sensormesswerten die Rede ist, ist dies nur für das konkrete Ausführungsbeispiel relevant. Ob sich eine Annäherung nämlich durch fallende Messwerte oder steigende Messwerte ausdrückt, hängt von der Art der Signaldarstellung und Schaltung der Näherungssensor-Elektroden ab. In Verfahrensblock 30 wird geprüft, ob die Signaldaten S1 und S2 für die Laufzeit des Timer t1 auf derselben Seite der zugeordneten Schwellwerte bleiben und diese nicht erneut kreuzen. Ist dies der Fall, wird ein erstes Bediensignal am Signalausgang der Steuer- und Auswerteeinrichtung ausgegeben. Ist dies nicht der Fall, wird das erste Bediensignal nicht ausgegeben. In jedem Fall wird nach Ablauf der Laufzeit des Timer t1 zu dem Block 20 des Verfahrens zurückgesprungen. Dort wird, unabhängig von der zuvor oder parallel durchgeführten Prüfung des Blocks 30, anhand der Messwerte S1 und S2 der Näherungssensoren geprüft, ob ein gültiges Bedienereignis vorliegt. Die dafür erforderliche Zeitdauer kann deutlich länger sein als die Zeitdauer tz1 und entsprechend auch weitere Messwerte gegenüber dem Verfahren aus Block 30 berücksichtigen. Die Auswertung eines solchen gültigen Bedienereignisses kann anhand komplexer Kriterien und mit deutlich höherem Rechenaufwand durchgeführt werden, wobei beispielsweise gespeicherte Messwerte für einen bestimmten Zeitbereich einem Mustervergleich unterzogen werden oder in ein neuronales Netz eingespeist werden. Auch eine Vielzahl an Schwellwert-Vergleichskriterien kann eingesetzt werden, um ein gültiges Bedienereignis zu erkennen. Sofern in Block 20 ein gültiges Bedienereignis erkannt wurde wird geprüft, ob ein erstes Bediensignal gesendet wurde. Falls in dem zuvor oder parallel ausgeführten Block 30 kein gültiges Bediensignal ausgegeben wurde, wird zunächst das erste Bediensignal ausgegeben. Anschließend wird das zweite Bediensignal, welches eine Erkennung des gültigen Bedienereignisses kennzeichnet ausgegeben. Zwischen dem ersten Bediensignal und dem zweiten Bediensignal fügt die Steuer- und Auswerteeinrichtung dabei einen vorgegebenen Mindestzeitabstand ein.

Es ist in diesem Ablauf also jederzeit gewährleistet, dass einem zweiten Bediensignal immer das erste Bediensignal vorangeht, selbst wenn es nicht im Rahmen der Erkennung in Block 30 gesendet wurde.

Wird in Block 20 jedoch entschieden, dass kein gültiges Bediensignal erkannt wurde wird ebenfalls zunächst geprüft, ob das erste Bediensignal in Block 30 erzeugt wurde. Ist dies nicht der Fall wird das Verfahren beendet und die Messwerte S1 und S2 werden erneut überwacht. Sofern jedoch das erste Bediensignal in Block 30 gesendet wurde, wird nun ein Fehlbetätigungssignal 1 von der Steuer- und Auswerteeinrichtung ausgegeben. Anschließend wird zur Überwachung der Sensoren zurückgekehrt.

Wird in Block 20 jedoch entschieden, dass kein gültiges Bediensignal erkannt wurde und das erste Bediensignal wurde nicht ausgegeben, wird ein Fehlbetätigungssignal 2 von der Steuer- und Auswerteeinrichtung ausgegeben. Anschließend wird zur Überwachung der Sensoren zurückgekehrt.

Fehlbetätigungssignal 1 und Fehlbetätigungssignal 2 unterscheiden sich derart, dass eine nachgeordnete Unterscheidung möglich ist, insbesondere in ihrer Signaldauer und/oder ihrem codierten Signalinhalt. Die Unterscheidung, ob der Fehlbetätigung eine Ausgabe eines ersten Bediensignals vorausging erlaubt eine differenzierte Weiterverarbeitung. Zum Beispiel können dem Benutzer die verschiedenen Fehlbetätigungszustände in passender Weise signalisiert werden. Wurde dem Benutzer auf das erste Bediensignal hin bereits eine laufende Auswertung signalisiert, so kann dann über dieselben Signalmittel die Fehlbetätigung signalisiert werden, weil davon auszugehen ist, dass der Benutzer diese Signalmittel weiterhin beachtet. Eine Fehlbetätigung ohne vorhergehende Signalisierung kann z.B. stumm ausgewertet werden, es kann jedoch eine Speicherung des Vorgangs im Service-Speicher erfolgen oder einem vom Benutzer mitgeführten ID-Geber oder Mobilgerät eine entsprechende Fehlbetätigungs-Mitteilung übermittelt werden. Unternimmt nämlich ein Benutzer einen Betätigunsversuch, der einen Auswertevorgang auslöst kann er anhand der Mitteilung unterscheiden, ob überhaupt eine Auswertung gestartet wurde.

Welche Reaktionen seitens der zentralen Steuereinrichtung 5 auf einerseits das erste Bediensignal und andererseits das zweite Bediensignal und das Fehlbetätigungssignal erfolgen ist abhängig von dem Einsatzzweck und dem jeweiligen Fahrzeughersteller, der ein entsprechendes System verbaut. Wie oben bereits beschrieben, kann ein erstes Bediensignal insbesondere verwendet werden, um dem Benutzer eine laufende Überprüfung seiner Betätigung zu signalisieren. Alternativ kann das erste Bediensignal verwendet werden, um ein vom Benutzer mitgeführtes Legitimierungsmittel, beispielsweise einen Funkschlüssel, in eine Funkkommunikation einzubeziehen. In einer solchen Funkkommunikation kann beispielsweise die Entfernung zu einem legitimen Fahrzeugschlüssel durch das Fahrzeug überprüft werden, während andererseits die tatsächliche Bedienungserkennung noch läuft. Ebenso kann das Fehlbetätigungssignal verwendet werden, um eine entsprechende Mitteilung an den Benutzer oder das mitgeführte Legitimierungsmittel zu senden und gegebenenfalls einen Funkdialog wieder abzubrechen.

## Patentansprüche

1. Verfahren zur Auswertung einer Sensorvorrichtung, wobei die Sensorvorrichtung wenigstens einen Näherungssensor (2, 3) aufweist, welcher die räumliche Annäherung von Körpern (6a, 6b) erfasst und wobei die Sensorvorrichtung wenigstens eine Steuer- und Auswerteeinrichtung (4) aufweist, welche mit dem Näherungssensor gekoppelt ist und welche einen Signalausgang aufweist,
mit den Schritten,
wiederholtes Erfassen der Sensormesswerte des Näherungssensors (2, 3) mit der Steuer- und Auswerteeinrichtung,
Falls die Sensormesswerte eine beginnende Betätigung der Sensorvorrichtung charakterisieren, dann
- Starten eines ersten Timers t1,
- wiederholtes Erfassen der Sensormesswerte des wenigstens einen Näherungssensors (2, 3) mit der Steuer- und Auswerteeinrichtung,
- wobei dann, wenn der erste Timer einen ersten Zielwert tz1 erreicht hat und die Sensormesswerte ein erstes Kriterium seit dem Start des ersten Timers durchgehend erfüllen, ein erstes Bediensignal an dem Signalausgang der Steuer- und Auswerteeinrichtung (4) ausgegeben wird,
- fortgesetztes Erfassen der Sensormesswerte des wenigstens einen Näherungssensors mit der Steuer- und Auswerteeinrichtung (4),
- wobei dann, wenn die Sensormesswerte ein zweites Kriterium erfüllen, welches zur Erkennung einer gültigen Ausführung einer Bediengeste ausgebildet ist, ein zweites Bediensignal an dem Signalausgang ausgegeben wird,
- wobei sonst, wenn die Sensormesswerte das zweite Kriterium nicht erfüllen, ein Fehlbetätigungssignal an dem Signalausgang ausgegeben wird,
- wobei sich das erste Bediensignal, das zweite Bediensignal und das Fehlbetätigungssignal charakteristisch unterscheiden,
**dadurch gekennzeichnet, dass**
eine charakteristische Eigenschaft des Fehlbetätigungssignals durch die Steuer- und Auswerteeinrichtung in Abhängigkeit davon eingestellt wird, ob das erste Bediensignal ausgegeben wurde.

2. Verfahren nach Patentanspruch 1, wobei die Ausgabe des Fehlbetätigungssignals in Abhängigkeit von der Ausgabe des ersten Bediensignals erfolgt.

3. Verfahren nach einem der vorangehenden Patentansprüche, wobei sich das erste und das zweite Bediensignal und das Fehlbetätigungssignal in ihrer Signaldauer unterscheiden.

4. Verfahren nach einem der vorangehenden Patentansprüche, wobei sich das erste und das zweite Bediensignal in ihrem Signalinhalt unterscheiden.

5. Verfahren nach einem der vorangehenden Patentansprüche, wobei das erste Kriterium eine Bedingung enthält, wonach die Sensormesswerte einen vorgegebenen ersten Schwellwert nicht kreuzen.

6. Verfahren nach einem der vorangehenden Patentansprüche, wobei die Sensorvorrichtung wenigstens zwei Näherungssensoren (2, 3) aufweist, welche jeweils Sensormesswerte liefern und wobei dann, wenn der erste Timer den ersten Zielwert erreicht hat und die Sensormesswerte sämtlicher Näherungssensoren (2, 3) ein jeweils zugeordnetes erstes Kriterium seit dem Start des ersten Timers durchgehend erfüllen, ein erstes Bediensignal an dem Signalausgang ausgegeben wird.

7. Verfahren nach Patentanspruch 6, wobei das jedem Näherungssensor jeweils zugeordnete erste Kriterium ein spezifischer Schwellwert ist, den die Sensormesswerte des jeweiligen Näherungssensors (2, 3) nicht kreuzen dürfen.

8. Verfahren nach einem der vorangehenden Patentansprüche, wobei das zweite Kriterium eine Bedingung enthält, wonach eine gültige Ausführung einer Bediengeste innerhalb einer Laufzeit des Timers t1 und vor Erreichen eines zweiten Zielwertes tz2 durch den Timer t1 erkannt werden muss.

9. Verfahren nach einem der vorangehenden Patentansprüche, wobei die Steuer- und Auswerteeinrichtung die Ausgabe von Signalen, die am Signalausgang ausgegeben werden, bedarfsweise derart verzögert, dass zwischen den Signalen jeweils einen zeitlicher Mindestabstand td eingehalten wird.

10. Verfahren nach einem der vorangehenden Patentansprüche, wobei das erste Bediensignal und/oder das Fehlbetätigungssignal mit einer Verarbeitungseinheit empfangen wird/werden und als Trigger zur Auslösung einer optischen oder akustischen Signaleinrichtung verwendet wird.

11. Verfahren nach einem der vorangehenden Patentansprüche, wobei das erste Bediensignal mit einer Verarbeitungseinheit empfangen wird und als Trigger zur Auslösung einer drahtlosen Funkkommunikation zur Berechtigungsabfrage eines vom Bediener mitgeführten ID-Gebers verwendet wird.

12. Verfahren nach einem der vorangehenden Patentansprüche, wobei dann,
- wenn durch die Steuer- und Auswerteeinrichtung (4) eine gültige Bedienung festgestellt wird, und dann
- wenn noch kein erstes Bediensignal ausgegeben wurde, zunächst das erstes Bediensignal an dem Signalausgang der Steuer- und Auswerteeinrichtung (4) ausgegeben wird und nachfolgend das zweite Bediensignal an dem Signalausgang ausgegeben wird.

## Claims

1. Method for evaluating a sensor device,
wherein the sensor device comprises at least one proximity sensor (2, 3) which detects the spatial approach of bodies (6a, 6b), and wherein the sensor device comprises at least one control and evaluation unit (4) which is coupled to the proximity sensor and which has a signal output,
comprising the steps of:
- repeatedly detecting the sensor measurement values of the proximity sensor (2, 3) by means of the control and evaluation unit,
- if the sensor measurement values characterize the beginning of an actuation of the sensor device, then
- starting a first timer t1,
- repeatedly detecting the sensor measurement values of the at least one proximity sensor (2, 3) by means of the control and evaluation unit,
- wherein, when the first timer has reached a first target value tz1 and the sensor measurement values have continuously fulfilled a first criterion since the start of the first timer, a first operating signal is output at the signal output of the control and evaluation unit (4),
- continuing to detect the sensor measurement values of the at least one proximity sensor by means of the control and evaluation unit (4),
- wherein, if the sensor measurement values fulfil a second criterion that is configured to recognise a valid execution of an operating gesture, a second operating signal is output at the signal output,
- wherein, otherwise, if the sensor measurement values do not fulfil the second criterion, an erroneous operation signal is output at the signal output,
- wherein the first operating signal, the second operating signal, and the erroneous operation signal differ characteristically,
**characterised in that**
a characteristic property of the erroneous operation signal is adjusted by the control and evaluation unit depending on whether the first operating signal has been output.

2. Method according to claim 1,
wherein the output of the erroneous operation signal depends on the output of the first operating signal.

3. Method according to one of the preceding claims,
wherein the first and second operating signals and the erroneous operation signal differ in their signal duration.

4. Method according to one of the preceding claims,
wherein the first and second operating signals differ in their signal content.

5. Method according to one of the preceding claims,
wherein the first criterion comprises a condition according to which the sensor measurement values do not cross a predetermined first threshold value.

6. Method according to one of the preceding claims,
wherein the sensor device comprises at least two proximity sensors (2, 3), each providing sensor measurement values, and wherein, when the first timer has reached the first target value and the sensor measurement values of all proximity sensors (2, 3) have continuously fulfilled a respective assigned first criterion since the start of the first timer, a first operating signal is output at the signal output.

7. Method according to claim 6,
wherein the first criterion assigned to each proximity sensor is a specific threshold value which the sensor measurement values of the respective proximity sensor (2, 3) must not cross.

8. Method according to one of the preceding claims,
wherein the second criterion comprises a condition according to which a valid execution of an operating gesture must be detected within the runtime of timer t1 and before the timer t1 reaches a second target value tz2.

9. Method according to one of the preceding claims,
wherein the control and evaluation unit, if necessary, delays the output of signals that are output at the signal output in such a way that a minimum time interval td is maintained between the signals.

10. Method according to one of the preceding claims,
wherein the first operating signal and/or the erroneous operation signal is/are received by a processing unit and used as a trigger for activating an optical or acoustic signalling device.

11. Method according to one of the preceding claims,
wherein the first operating signal is received by a processing unit and used as a trigger for initiating wireless radio communication for authorisation verification of an ID transmitter carried by the operator.

12. Method according to one of the preceding claims,
wherein
- if a valid operation is detected by the control and evaluation unit (4), and
- if no first operating signal has yet been output,
the first operating signal is first output at the signal output of the control and evaluation unit (4), and subsequently the second operating signal is output at the signal output.

## Revendications

1. Procédé d'évaluation d'un dispositif de capteur,
le dispositif de capteur comprenant au moins un capteur de proximité (2, 3) qui détecte le rapprochement spatial de corps (6a, 6b), et comprenant au moins une unité de commande et d'évaluation (4) couplée audit capteur de proximité et présentant une sortie de signal,
comprenant les étapes suivantes :
- détection répétée, au moyen de l'unité de commande et d'évaluation, des valeurs de mesure du capteur de proximité (2, 3),
- si les valeurs de mesure du capteur caractérisent le début d'un actionnement du dispositif de capteur, alors
- démarrage d'un premier minuteur t1,
- détection répétée des valeurs de mesure du (ou des) capteur(s) de proximité (2, 3) au moyen de l'unité de commande et d'évaluation,
- lorsque le premier minuteur a atteint une première valeur cible tz1 et que les valeurs de mesure du capteur satisfont en continu un premier critère depuis le démarrage du minuteur, émission, à la sortie de signal de l'unité de commande et d'évaluation (4), d'un premier signal de commande,
- poursuite de la détection des valeurs de mesure du (ou des) capteur(s) de proximité au moyen de l'unité de commande et d'évaluation (4),
- lorsque les valeurs de mesure du capteur satisfont un deuxième critère conçu pour reconnaître l'exécution valide d'un geste de commande, émission, à la sortie de signal, d'un deuxième signal de commande,
- dans le cas contraire, lorsque les valeurs de mesure ne satisfont pas le deuxième critère, émission, à la sortie de signal, d'un signal de fausse manipulation,
- le premier, le deuxième et le signal de fausse manipulation se différenciant par leurs caractéristiques propres,
**caractérisé en ce qu'**une propriété caractéristique du signal de fausse manipulation est ajustée par l'unité de commande et d'évaluation en fonction du fait que le premier signal de commande a été émis ou non.

2. Procédé selon la revendication 1,
dans lequel la sortie du signal de fausse manipulation dépend de la sortie du premier signal de commande.

3. Procédé selon l'une des revendications précédentes,
dans lequel le premier et le deuxième signaux de commande ainsi que le signal de fausse manipulation se différencient par leur durée de signal.

4. Procédé selon l'une des revendications précédentes,
dans lequel le premier et le deuxième signaux de commande se différencient par leur contenu de signal.

5. Procédé selon l'une des revendications précédentes,
dans lequel le premier critère comprend une condition selon laquelle les valeurs de mesure du capteur ne franchissent pas un premier seuil prédéterminé.

6. Procédé selon l'une des revendications précédentes,
dans lequel le dispositif de capteur comprend au moins deux capteurs de proximité (2, 3) fournissant chacun des valeurs de mesure, et dans lequel, lorsque le premier minuteur a atteint la première valeur cible et que les valeurs de mesure de l'ensemble des capteurs de proximité (2, 3) satisfont en continu un critère premier respectivement associé depuis le démarrage du minuteur, un premier signal de commande est émis à la sortie de signal.

7. Procédé selon la revendication 6,
dans lequel le critère premier associé à chaque capteur de proximité est un seuil spécifique que les valeurs de mesure du capteur correspondant (2, 3) ne doivent pas franchir.

8. Procédé selon l'une des revendications précédentes,
dans lequel le deuxième critère comprend une condition selon laquelle une exécution valide d'un geste de commande doit être détectée dans la durée de fonctionnement du minuteur t1 et avant que le minuteur t1 n'atteigne une deuxième valeur cible tz2.

9. Procédé selon l'une des revendications précédentes,
dans lequel l'unité de commande et d'évaluation retarde, si nécessaire, la sortie des signaux émis à la sortie de signal de manière à maintenir un intervalle de temps minimal td entre les signaux.

10. Procédé selon l'une des revendications précédentes,
dans lequel le premier signal de commande et/ou le signal de fausse manipulation est/sont reçu(s) par une unité de traitement et utilisé(s) comme déclencheur pour l'activation d'un dispositif de signalisation optique ou acoustique.

11. Procédé selon l'une des revendications précédentes,
dans lequel le premier signal de commande est reçu par une unité de traitement et utilisé comme déclencheur pour initier une communication radio sans fil destinée à la vérification d'autorisation d'un émetteur d'identification porté par l'opérateur.

12. Procédé selon l'une des revendications précédentes,
dans lequel
- lorsqu'une commande valide est détectée par l'unité de commande et d'évaluation (4), et
- lorsqu'aucun premier signal de commande n'a encore été émis,
le premier signal de commande est d'abord émis à la sortie de signal de l'unité de commande et d'évaluation (4), puis le deuxième signal de commande est émis à ladite sortie de signal.
